# EUROPEAN PATENT APPLICATION

(11) **EP 4 718 993 A1**
(43) Date of publication of application: **01.04.2026**
(21) Application number: 25194612.5
(22) Date of filing: 07.08.2025
(51) Int. Cl.: H10D 84/01, H10D 84/85, H10D 84/03

(54) **HYBRID (100)-SURFACE AND (110)-SURFACE RIBBON FETS IN INTEGRATED PROCESS FLOW**

(30) Priority: 26.09.2024 US 202418897946
(71) Applicant: INTEL Corporation, Santa Clara, CA 95054 (US)
(72) Inventor: Lee, Chen-Guan, Portland, OR 97229 (US)
(74) Representative: Samson & Partner Patentanwälte mbB

(57) **Abstract**

Integrated circuit (IC) devices having nonplanar transistor structures of complementary conductivity type.

An IC device includes first and second transistors with a stack of nanoribbons in a channel region of the first transistor and one or more fins in a channel region of the second transistor, and the one or more fins may be on a trench isolation over the substrate. The nanoribbons may have upper and lower (100) surfaces, and sidewalls of the one or more fins may be (110) surfaces. The fins on the isolation structure may be between stacks of nanoribbons, the nanoribbons may be over subfins of the substrate, and the isolation structure may be between the subfins.

The fins may be epitaxially grown as vertical nanoribbons from (and with a same crystal lattice and alignment as) a sidewall of the stack of nanoribbons in the first transistor.

## Description

### BACKGROUND

Gate-all-around (GAA) field-effect transistors (FETs) offer improvements over FinFETs, such as the capability to modulate channel width with nanoribbon width, increased electrostatic control of the FET channel by the gate (and so higher on/off current ratios), etc. However, the transition of metal-oxide-semiconductor (MOS) FETs away from fins as channels generally degrades PMOS performance relative to NMOS performance, for example, due to differences in electron and hole mobilities on the dominant transport surfaces of the channel structures. Assuming a conventional (100) silicon substrate, large (110) sidewalls of a FinFET channel are well-suited to PMOS, but the top and bottom (100) surfaces of nanoribbons (or nanosheets) in a GAA FET are more suitable for NMOS conduction. While employing other silicon substrates, such as (110) wafers, may address this PMOS issue, this re-orientation may instead cause a similar NMOS degradation (as well as introducing other issues, e.g., wafer cleaving).

New techniques and structures are needed to improve the performance of CMOS devices, for example, by employing configurations optimized for each of NMOS and PMOS FETs.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements, e.g., with the same or similar functionality. The disclosure will be described with additional specificity and detail through use of the accompanying drawings:
FIGS. 1A, 1B, and 1C illustrate cross-sectional profile and plan views of an integrated circuit (IC) device having a FinFET (field-effect transistor) structure adjacent gate-all-around (GAA) FET structures, in accordance with some embodiments;
FIG. 2 is a flow chart of methods for forming both FinFET and nanoribbon GAA FET channels in a same IC device, in accordance with some embodiments;
FIGS. 3A, 3B, 3C, 3D, 3E, 3F, 3G, and 3H illustrate cross-sectional profile and plan views of a workpiece or device having a FinFET structure adjacent GAA FET structures, at various stages of manufacture, in accordance with some embodiments;
FIG. 4 illustrates a diagram of an example data server machine employing an IC device having nanoribbons and fins as channels in adjacent transistors; and
FIG. 5 is a block diagram of an example computing device, in accordance with some embodiments.

### DETAILED DESCRIPTION

In the following detailed description, reference is made to the accompanying drawings that show, by way of illustration, specific embodiments in which the claimed subject matter may be practiced. These embodiments are described in sufficient detail to enable those skilled in the art to practice the subject matter. The various embodiments, although different, are not necessarily mutually exclusive. For example, a particular feature, structure, or characteristic described herein, in connection with one embodiment, may be implemented within other embodiments without departing from the spirit and scope of the claimed subject matter.

References within this specification to "one embodiment" or "an embodiment" mean that a particular feature, structure, or characteristic described in connection with the embodiment is included in at least one implementation encompassed within the present description. Therefore, the use of the phrase "one embodiment" or "in an embodiment" does not necessarily refer to the same embodiment. In addition, the location or arrangement of individual elements within each disclosed embodiment may be modified without departing from the spirit and scope of the claimed subject matter. The following detailed description is, therefore, not to be taken in a limiting sense, and the scope of the subject matter is defined only by the appended claims, appropriately interpreted, along with the full range of equivalents to which the appended claims are entitled.

The terms "over," "to," "between," and "on" as used herein may refer to a relative position of one layer with respect to other layers. One layer "over" or "on" another layer or bonded "to" another layer may be directly in contact with the other layer or may have one or more intervening layers. One layer "between" layers may be directly in contact with the layers or may have one or more intervening layers.

The terms "coupled" and "connected," along with their derivatives, may be used herein to describe structural relationships between components. These terms are not intended as synonyms for each other. Rather, in particular embodiments, "connected" may be used to indicate that two or more elements are in direct physical or electrical contact with each other. "Coupled" may be used to indicate that two or more elements are in either direct or indirect (with other intervening elements between them) physical or electrical contact with each other, and/or that the two or more elements co-operate or interact with each other (e.g., as in a cause-and-effect relationship, an electrical relationship, a functional relationship, etc.).

The term "circuit" or "module" may refer to one or more passive and/or active components that are arranged to cooperate with one another to provide a desired function. The term "signal" may refer to at least one current signal, voltage signal, magnetic signal, or data/clock signal. The meaning of "a," "an," and "the" include plural references. The meaning of "in" includes "in" and "on."

The vertical orientation is in the z-direction and recitations of "top," "bottom," "above," and "below" refer to relative positions in the z-dimension with the usual meaning. However, embodiments are not necessarily limited to the orientations or configurations illustrated in the figure.

The terms "substantially," "close," "approximately," "near," and "about," generally refer to being within +/- 10% of a target value (unless specifically specified). Unless otherwise specified in the specific context of use, the term "predominantly" means more than 50%, or more than half. For example, a composition that is predominantly a first constituent means more than half of the composition is the first constituent. The term "primarily" means the most, or greatest, part. For example, a composition that is primarily a first constituent means the composition has more of the first constituent than any other constituent. A composition that is primarily first and second constituents means the composition has more of the first and second constituents than any other constituent.

Unless otherwise specified the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional," "profile," and "plan" correspond to orthogonal planes within a cartesian coordinate system. Thus, cross-sectional and profile views are taken in the x-z and y-z planes, and plan views are taken in the x-y plane. Typically, profile views in the x-z plane are cross-sectional views. Where appropriate, drawings are labeled with axes to indicate the orientation of the figure.

Structures and techniques are disclosed to improve integrated circuit (IC) devices having gate-all-around (GAA) metal-oxide-semiconductor (MOS) field-effect transistors (FETs) implemented in complementary MOS (CMOS) technology.

The structures described herein employ both GAA and fin FETs, e.g., utilizing each channel structure where a corresponding lattice structure and surface orientation are most favorable to a particular FET conductivity type. In (100) silicon substrates, for example, GAA FETs having nanoribbon channel structures (e.g., with larger top and bottom (100) surfaces and minimal (110) sidewall surfaces) may be deployed in NMOS FETs, and PMOS FinFETs may take advantage of larger fin (110) sidewall surfaces.

The FinFETs may be formed unconventionally, e.g., in close proximity to a stack of nanoribbons and without the need for fin etches that cut the fins from a semiconductor substrate. A material stack may be grown up from a crystalline substrate (e.g., a (100) silicon wafer) and may include layers of channel material interleaved with layers of sacrificial material, for example, in a GAA FET process for fabricating a stack of nanoribbons. A second material stack may then be grown off a sidewall of the first, GAA FET material stack with the FinFET fins grown as vertically oriented nanoribbons, part of the second, laterally grown material stack.

Grown from the crystalline substrate, the first material stack and (laterally oriented) nanoribbons may include the same lattice structure (e.g., continuous, aligned with the same orientation), and the lattice structure may then be conserved in the fins (or vertically oriented nanoribbons), grown from the first material stack and nanoribbons. Having surfaces of different crystal planes (e.g., (100) and (110)), the vertically oriented nanoribbons (or fins) and the laterally oriented nanoribbons may advantageously be employed in transistors of complementary conductivity type. For example, a FinFET with (110) sidewalls may have a p-type work function metal (WFM) in a gate electrode over a channel fin and acceptor (p-type) impurities as a dopant in source and drain bodies on either end of the channel fin. A GAA FET with (100) upper and lower nanoribbon surfaces may have an n-type WFM in a gate electrode (over and between the nanoribbons in a stack) and donor (n-type) impurities as a dopant in source and drain bodies on the ends of the nanoribbons.

While the GAA FET nanoribbons may be over a subfin region of the crystalline substrate, the FinFET fin(s) may be over a trench isolation dielectric, e.g., between subfins and GAA FETs, which may be an indication of the described fabrication process. The fin(s) may be directly on the isolation dielectric, which may form a base under the FinFET fin(s).

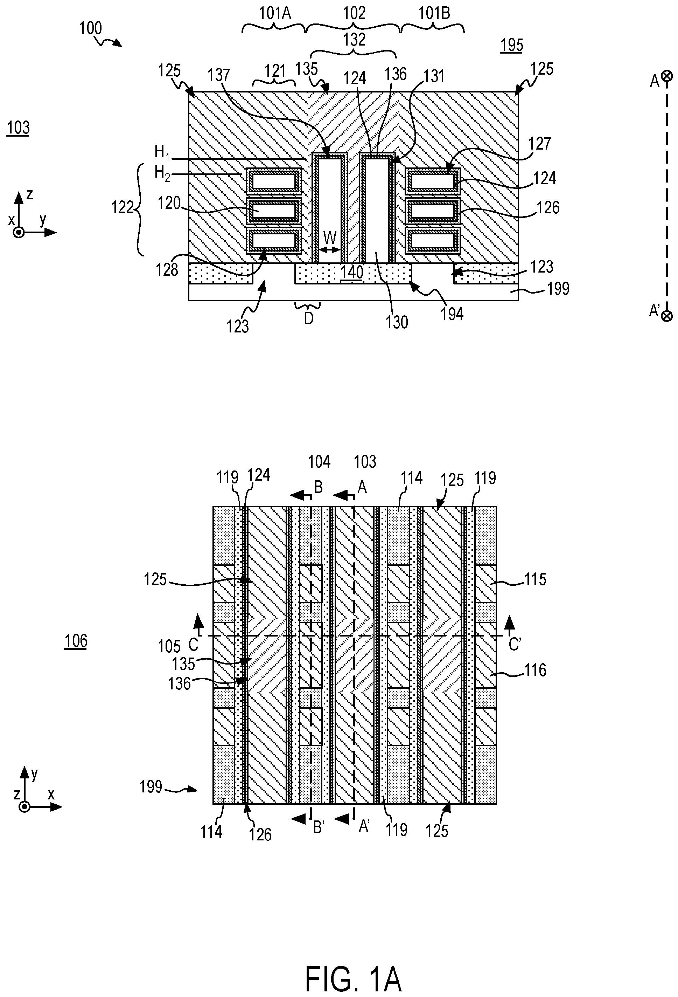

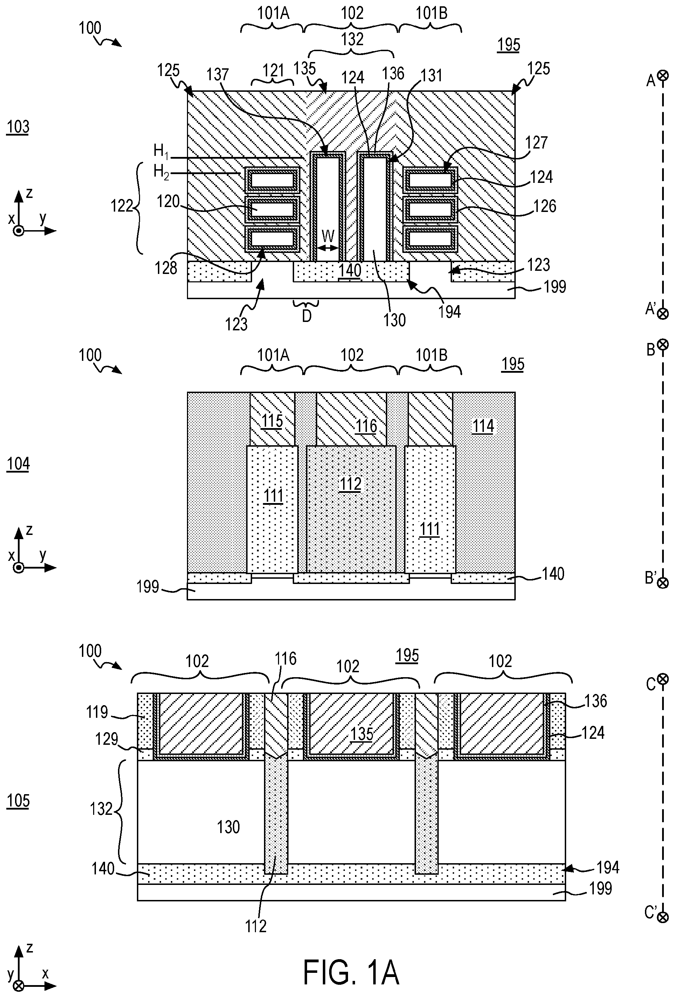

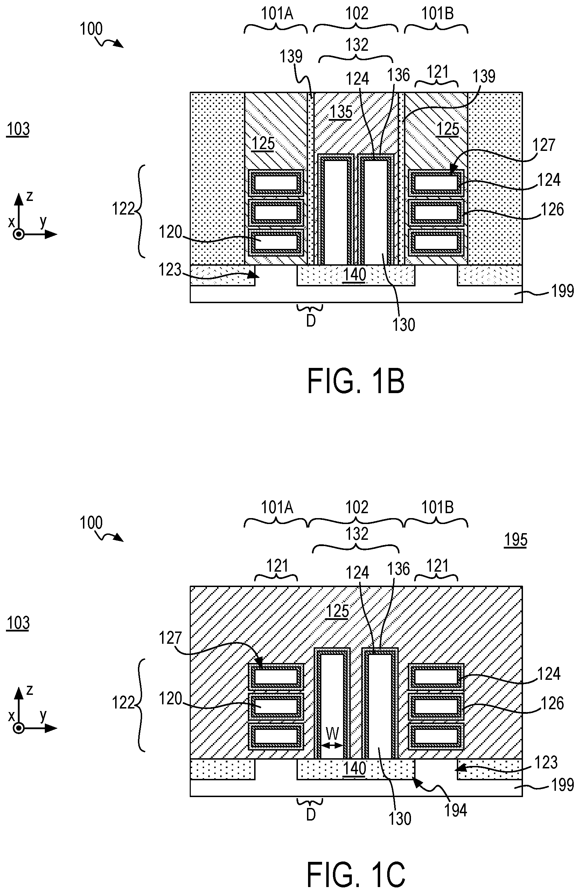

FIGS. 1A, 1B, and 1C illustrate cross-sectional profile and plan views of an IC device 100 having FinFET structure 102 adjacent GAA FET structures 101, in accordance with some embodiments. Views 103, 104, 105 are profile views through different cross sections of device 100, parallel views 103, 104 at y-z planes transversely through first and second channel regions 121, 132 and source and drain bodies 111, 112, respectively, and view 105 an x-z plane longitudinally through a fin channel region 132. Plan view 106 shows the relative orientations of profile views 103, 104, 105 and their respective viewing planes A-A', B-B', and C-C'. FIG. 1A shows abutting gate electrodes 125, 135 over nanoribbons 120 in GAA FET structures 101 and fins 130 in FinFET structure 102. FIG. 1B illustrates gate electrode 135 over fins 130 in FinFET structure 102 and separate gate electrodes 125 over nanoribbons 120 in GAA FET structures 101. FIG. 1C shows a shared gate electrode 125 over fins 130 in FinFET structure 102 and over nanoribbons 120 in GAA FET structures 101.

FIG. 1A shows IC device 100, including transistor structure 102 between transistor structures 101A, 101B. Profile view 103 is first shown with the mapping context of plan view 106 and then again with fellow profile views 104, 105. As illustrated in view 103, GAA FET structures 101A, 101B each include a stack 122 of nanoribbons 120 in a first channel region 121 over a substrate 199. Each stack 122 of nanoribbons 120 extends in the x-directions, coupling between first source and drain bodies 111 in transistor structures 101. View 104 shows one of source and drain bodies 111 of each of transistor structures 101A, 101B. Nanoribbons 120 are lateral nanoribbons 120, e.g., with substantially horizontal upper (or top) and lower (or bottom) surfaces 127, 128 larger than small sidewalls of nanoribbons 120. In many embodiments, upper and lower surfaces 127, 128 of nanoribbons 120 are (100) surfaces, which may provide improved performance for NMOS transistor structures 101 (such as higher electron mobilities relative to (110) surfaces).

As illustrated in view 103, FinFET structure 102 includes multiple fins 130 in a second channel region 132 on a dielectric structure 140 over substrate 199. Fins 130 extend in the x-directions, both of fins 130 coupling between a pair of second source and drain bodies 112 in transistor structure 102. View 104 shows one of source and drain bodies 112 of transistor structure 102. Fins 130 stand substantially vertically, extending upwards from isolation structure 140, substantially orthogonal to nanoribbons 120. Fins 130 are vertical nanoribbons, e.g., with substantially vertical sidewalls 131 significantly larger than small upper surfaces 137 of fins 130. In many embodiments, sidewalls 131 of fins 130 are (110) surfaces, which may provide improved performance for PMOS transistor structures 102 (such as higher hole mobilities relative to (100) surfaces).

Substrate 199 includes multiple subfins 123. Each stack 122 of nanoribbons 120 is over a subfin 123. Isolation structure 140 is over substrate 199, between stacks 122 and between subfins 123 under each of stacks 122. Dielectric structure 140 is in a trench 194. Trench 194 is over substrate 199 and between subfins 123. For example, trench 194 and subfins 123 may be formed together, subfins 123 from substrate 199 by the opening of trench 194 in substrate 199. Each of subfins 123 is between a pair of structures 140 over substrate 199. Dielectric structure 140 may include any suitable dielectric material, such as an oxide (e.g., thermally grown over substrate 199). In many embodiments, structure 140 includes oxygen (e.g., in an oxide of silicon).

Transistor structures 101, 102 may have different dimensions or characteristics, e.g., as needed for a particular application or layout. For example, FET structures 101 may have more or fewer (or wider or narrower) nanoribbons 120, e.g., to match higher or lower current requirements or depending on space constraints. In the exemplary embodiment of FIG. 1A, GAA FET structures 101 each include three nanoribbons 120. In some embodiments, structures 101 include more than three nanoribbons 120. In some embodiments, structures 101 include fewer than three nanoribbons 120.

FinFET structure 102 includes two fins 130. In some embodiments, structure 102 includes more than two fins 130. In some embodiments, structure 102 includes fewer than two fins 130. FinFET structure 102 may have more or fewer (or taller or shorter) fins 130, e.g., to provide more or less current or depending on space constraints. Upper surface 137 of fins 130 is at a first height H₁ over second height H₂ of upper surface 127 of the stack 122 of nanoribbons 120. In some embodiments, for example, to provide more current, surface 137 of fins 130 is at a greater height H₁ over height H₂ of an uppermost surface 127 of nanoribbons 120. In some embodiments, height H₁ of fins 130 is one-and-a-half times height H₂ of nanoribbons 120. Fins 130 may be of a greater height H₁ than is typical of fins 130 in a FinFET, e.g., due to a fabrication process that allows the growing of fins 130 laterally from a material stack and without the need for a high-aspect ratio fin etch.

Transistor structures 101, 102 may have different spacings or orientations, e.g., to meet certain space constraints or minimize occupied layout areas. The spacing of channel regions 121, 132 may be reduced in applications with confined layouts. Stack 122 of nanoribbons 120 is separated from fins 130 by a distance D. In some embodiments, distance D is greater than a width W of a fin 130 and less than twice width W. Such spacing may provide sufficient distance between channel regions 121, 132 (e.g., for a sufficiently low capacitance between channel regions 121, 132) while not occupying an overly large area. In some embodiments, distance D is greater than twice width W, which may reduce a capacitance between channel regions 121, 132 and so improve performance. In some embodiments, distance D is less than width W, which may reduce an area occupied by structures 101, 102.

One or more gate dielectric layers 124 may be between channel regions 121, 132 and gate electrodes 125, 135. Gate dielectric layer 124 provides electrical insulation between channel regions 121, 132 and electrodes 125, 135. Layer 124 may have more than one layer. Layer 124 may be of any suitable material(s). The one or more layers of dielectric layer 124 may include a silicon oxide, silicon dioxide (e.g., SiO2), a silicon oxynitride, etc. Advantageously, gate layer 124 includes a high-permittivity ("high-K") dielectric, which may improve transconductance and so electrostatic control of channel regions 121, 132 by electrodes 125, 135. A high-k dielectric material may include one or more of various elements, such as hafnium, silicon, oxygen, titanium, tantalum, lanthanum, aluminum, zirconium, barium, strontium, yttrium, lead, scandium, niobium, and zinc, including in oxides of these elements and combinations of these elements. Any other suitable materials may be deployed.

Transistor structure 101 includes gate electrode 125. Nanoribbons 120 extend through electrode 125. Transistor structure 102 includes gate electrode 135 over first and second fins 130. Gate electrodes 125, 135 are abutting and are electrically coupled. Gate electrodes 125, 135 on gate dielectric layer 124 may include of at least one of a p-type WFM or an n-type WFM, depending on whether the transistor structure 101, 102 is a PMOS or an NMOS transistor. In many embodiments, gate electrode 125 and/or 135 is a stack of two or more metal layers. For example, a conformal or liner layer 126 or 136 is on dielectric layer(s) 124 and around a bulk or fill metal, between layer 124 and a bulk or fill metal. In the exemplary embodiment of FIG. 1A, gate electrodes 125, 135 include different fill metals. Gate electrodes 125, 135 may be coupled by contact structures or vias (not shown) to an interconnect network 195 over FET structures 101, 102.

A liner layer 126 or 136 may be a seed or barrier metal and/or a WFM adjacent one or both of channel regions 121, 132, e.g., to set or influence a gate threshold voltage V_{T}. In many embodiments, electrode 125 includes an n-type WFM layer 126. In many embodiments, electrode 125 includes p-type WFM layer 136. For a PMOS transistor, metals that may be used for the gate electrode include, but are not limited to, ruthenium, palladium, platinum, cobalt, nickel, and conductive metal oxides, e.g., ruthenium oxide. A p-type WFM layer will enable the formation of a PMOS gate electrode with a work function that is between about 4.9 eV and about 5.2 eV. For an NMOS transistor, metals that may be used for the gate electrode include, but are not limited to, hafnium, zirconium, titanium, tantalum, aluminum, alloys of these metals, and carbides of these metals such as aluminum carbide, hafnium carbide, zirconium carbide, titanium carbide, and tantalum carbide. An n-type WFM layer will enable the formation of an NMOS gate electrode with a work function that is between about 3.9 eV and about 4.2 eV. In some embodiments, bulk metals of electrodes 125, 135 are WFMs.

View 106 shows gate electrodes 125, 135 over nanoribbons 120 and fins 130. Gate dielectric layers 124 are on spacer layers 119, and gate metal liner layers 126 or 136 are on gate dielectric layers 124. Contact structures 115, 116 are over and through isolation dielectric 114 in trenches between electrodes 125. Spacer layers 119 are between electrodes 125, 135 and structures 115, 116. Isolation dielectric 114 is between electrodes 125, 135.

Plan view 106 shows the relative orientations of profile views 103 and viewing plane A-A', as well as profile views 104, 105 and their respective viewing planes B-B' and C-C'.

Profile view 103 is shown again together with fellow profile views 104, 105, e.g., to provide context for view 104, which is aligned in with view 103 on the y-axis.

View 104 illustrates drain and/or source bodies 111, 112. Drain and source bodies 111 are on ends of nanoribbons 120, and drain and source bodies 112 are on ends of fins 130. In many embodiments, transistor structures 101, 102 are physically symmetrical about channel regions 121, 132 (and gate electrodes, 125, 135), respectively, and identifiers of bodies 111, 112 as either drain bodies 111, 112 or source bodies 111, 112 may be reversed interchangeably in many contexts. However, the classification of bodies 111, 112 as source or drain bodies 111, 112 may be by the electrical relationships of transistor structures 101, 102 and bodies 111, 112 to other components in a given circuit (e.g., and the consequent direction of current flow through structures 101, 102 and bodies 111, 112).

Bodies 111, 112 are electrically and physically coupled to opposite ends of channel regions 121, 132, respectively. Source and drain bodies 111, 112 are impurity doped bodies, e.g., regions of semiconductor material doped with one or more electrically active impurities and having increased charge-carrier availabilities and associated conductivities. Bodies 111, 112 may be doped with opposite type (e.g., n- or p-type) impurities. Drain and source bodies 111, 112 may include a predominant semiconductor material, and one or more n-dopants (e.g., donor impurities, such as phosphorus, arsenic, or antimony) or p-type impurities (e.g., acceptor impurities, such as boron or aluminum). Other dopant materials may be used. In many embodiments, source and drain bodies 111 include donor impurities, and source and drain bodies 112 include acceptor impurities.

Drain and source bodies 111, 112 may be formed by any suitable means. Bodies 111, 112 may be epitaxially grown semiconductor regions, for example, of a Group IV semiconductor material (e.g., Si, Ge, SiGe, GeSn alloy). Other semiconductor materials may be employed. Bodies 111, 112 may are substantially crystalline. Source and drain bodies 111, 112 may be polycrystalline or substantially monocrystalline, e.g., having long-range order at least adjacent ends of channel regions 121, 132 and merging or joining into a unitary body with few grain boundaries. Bodies 111, 112 may be surrounded by isolation dielectric 114 (e.g., to both y-directions), which may fill the space between gate electrodes 125 and/or 135 (e.g., in adjacent FET structures 101, 102 having channel regions 121, 132 aligned in the y-directions, extending in the x-directions).

Drain and source bodies 111, 112 are coupled by contact structures 115, 116 to an interconnect network 195 over FET structures 101, 102. Contact structures 115, 116 may be formed of metal or other electrically conductive material, including an interface layer (e.g., a silicide layer) of a metal alloyed with the semiconductor material of body 111 or 112. Interconnect network 195 includes layers with interconnections or wires that provide electrical routing, generally formed of metal or other electrically conductive material. Adjacent interconnect layers may be formed of different materials and by different methods. Adjacent metallization and interconnect layers are interconnected by vias that may be characterized as part of the metallization layers or between the metallization layers. In the illustrated example, network 195 may be a front-side interconnect network 195 including M0, V0, M1, M2/V1, M3/V2, M4/V3, and M4-M12 metallization layers. However, network 195 may include any number of metallization layers such as eight or more metallization layers. Similarly, a back-side network 195 may include BM0, BM1, BM2, and BM3. However, network 195 may include any number of metallization layers such as two to five metallization layers.

Substrate 199 may include any suitable material or materials. In some examples, substrate 199 may include monocrystalline silicon (including silicon on insulator (SOI)), polycrystalline silicon, germanium, silicon germanium, a III-V alloy material (e.g., gallium arsenide), a silicon carbide (e.g., SiC), a sapphire (e.g., Al₂O₃), or any combination thereof. Substrate 199 may refer specifically to a base material (for example, a thick base or layer of semiconductor material) that other materials (such as metals and dielectrics) are built up on. In some contexts, substrate 199 may refer to a base material layer and any build-up layers, etc., over the base. In many embodiments, substrate 199 includes a semiconductor material under bodies 111, 112 and dielectric structures 140. In some such embodiments, trenches 194 are cut between channel regions 121 (e.g., nanoribbons 120) and into a silicon substrate 199. Substrate 199 may also include other semiconductor materials, metals, dielectrics, dopants, and other materials commonly found in semiconductor substrates.

View 105 shows an x-z plane longitudinally through channel regions 132 of (vertical nanoribbon or) fin 130. Drain and/or source bodies 112 are between adjacent FET structures 102 having channel regions 132 extending in the x-directions and aligned in the y-directions. Vertical nanoribbons or fins 130 are on isolation structure 140 over substrate 199. Gate electrode 135 is over channel region 132 of fin 130, and gate insulator layer 124 is between electrode 135 and fin 130. Layer 136 of electrode 135 is on layer 124. Drain and/or source bodies 112 and contacts 116 are separated from gate electrode 135 by dielectric layer 129 on fin 130 and by spacer layer 119. Layers 119, 129 provide electrical isolation between adjacent structures and advantageously include low-permittivity ("low-K") dielectric materials. Layers 119, 129 may also provide etch selectivities, e.g., during fabrication. In many embodiments, one or both of layers 119, 129 include oxygen and silicon. In some such embodiments, one or both of layers 119, 129 include nitrogen.

FIG. 1B and view 103 illustrate IC device 100 having gate isolations 139 between separate gate electrodes 125, 135. Device 100 includes first, second, and third transistor structures 101A, 101B, 102 over substrate 199. Device 100 includes stack 122 of lateral nanoribbons 120 in structure 101A and stack 122 of lateral nanoribbons 120 in structure 101B, each over a corresponding subfin 123 and between a pair of first source and drain bodies 111. FET structure 101 includes gate electrode 125. Device 100 includes vertical nanoribbon or fin 130 between a pair of source and drain bodies 112 in structure 102, between transistor structures 101A, 101B. FET structure 102 includes gate electrode 135. Fin 130 is on dielectric structure 140 in trench 194 over substrate 199. Trench 194 is between subfins 123.

Isolations 139 separate transistor structures 101, 102. Isolations 139 provide electrical isolation between adjacent structures 101, 102 and gate electrodes 125, 135 and advantageously include low-K dielectric materials. In many embodiments, one or both of layers 119, 129 include oxygen and silicon.

FIG. 1C shows view 103 of IC device 100 including shared gate electrode 125 over channel regions 121, 132. Transistor structures 101, 102 include gate electrode 125. Gate electrode 125 includes WFM layers 126, 136 of complementary conductivity types. In the exemplary embodiment of FIG. 1C, gate electrode 125 includes a same fill metal over n-type WFM layer 126 and p-type WFM layer 136.

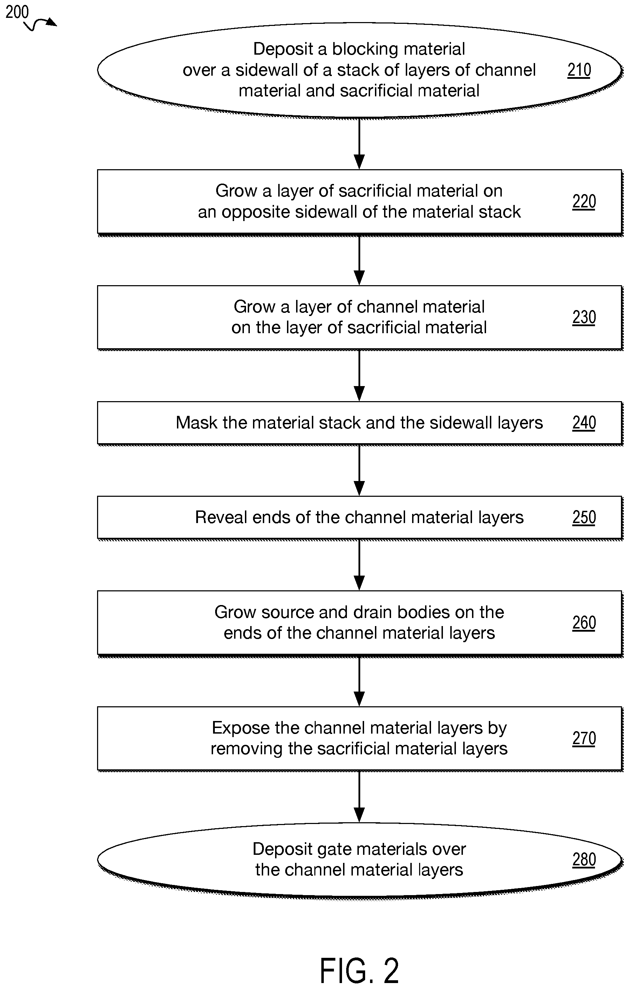

FIG. 2 is a flow chart of methods 200 for forming both FinFET and nanoribbon GAA FET channels in a same IC device, in accordance with some embodiments. Methods 200 include operations 210-280. Some operations shown in FIG. 2 are optional. Additional operations may be included. FIG. 2 shows an example sequence, but the operations can be done in other orders as well, and some operations may be omitted. Some operations can also be performed multiple times before other operations are performed. Some operations may be included within other operations so that the number of operations illustrated FIG. 2 is not a limitation of the methods 200.

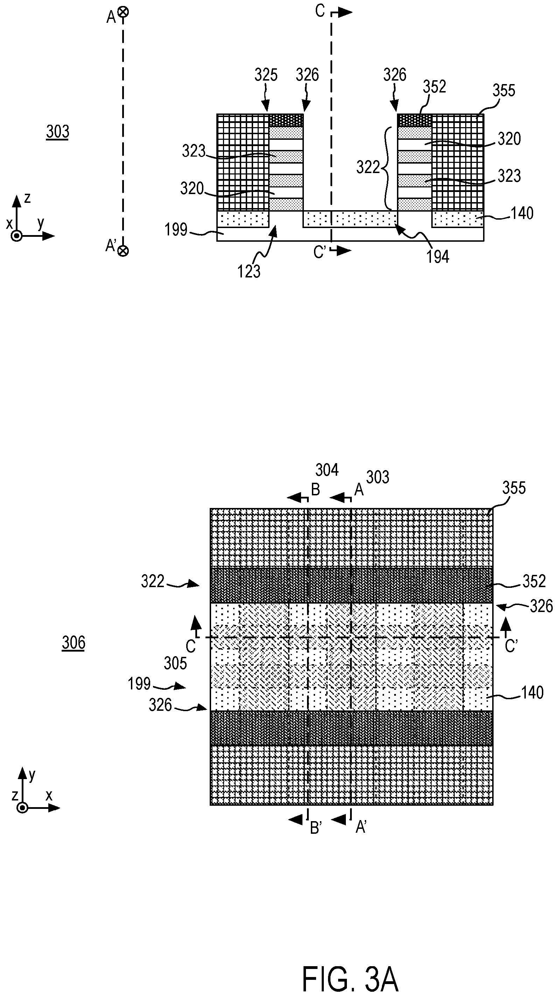

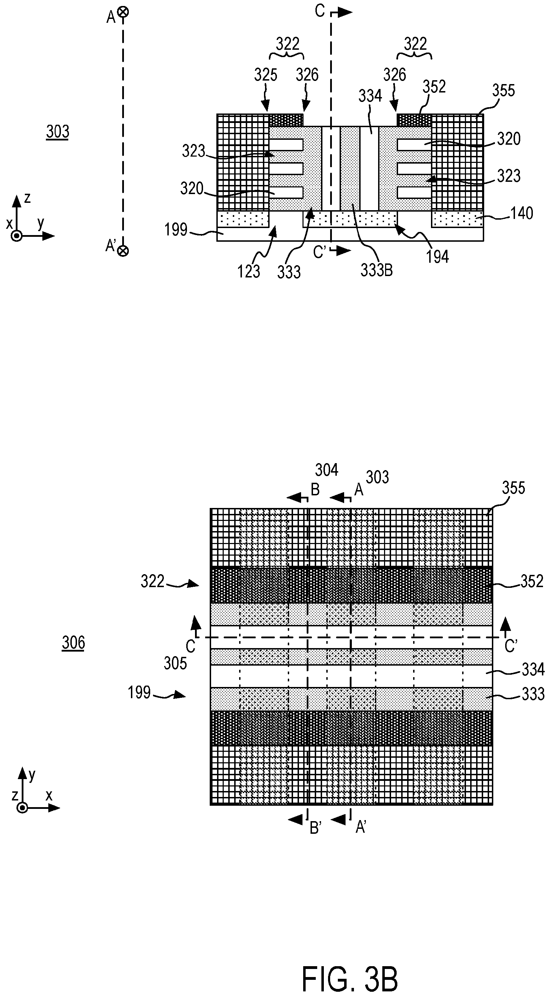

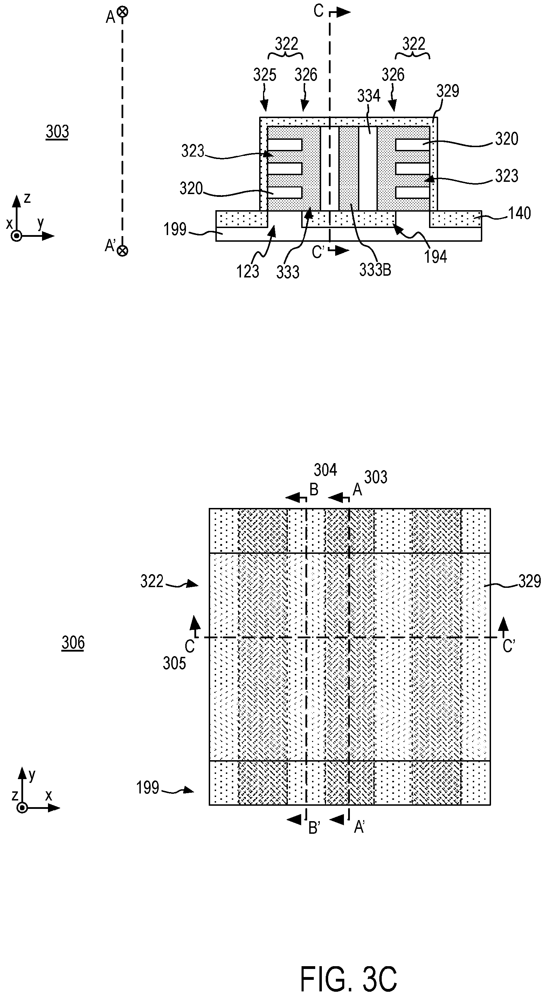

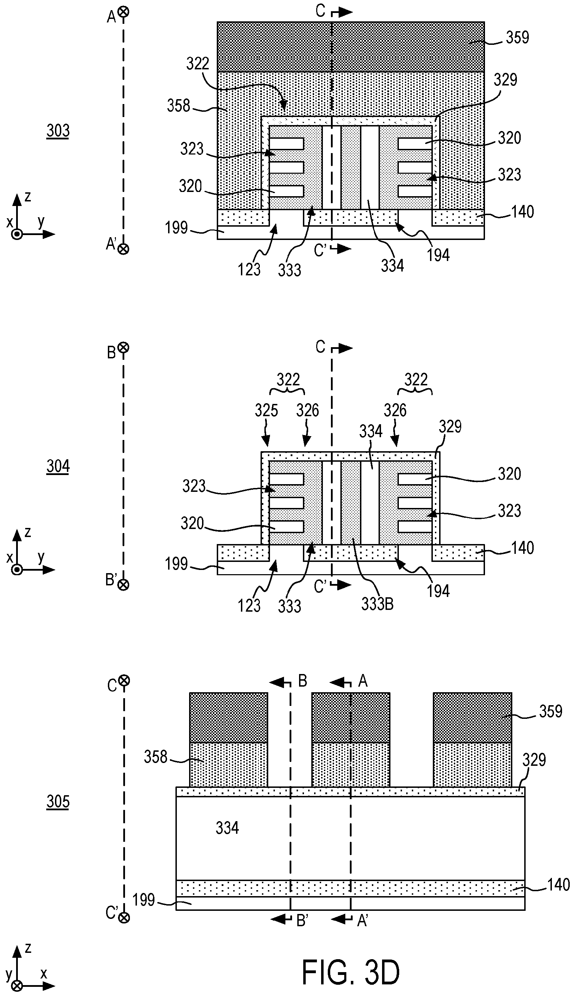

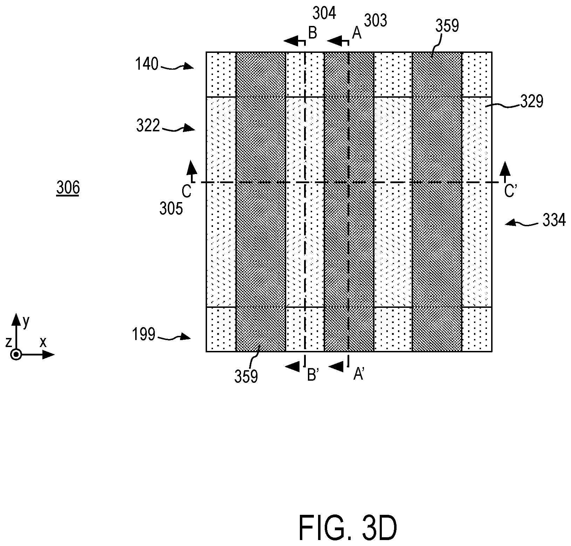

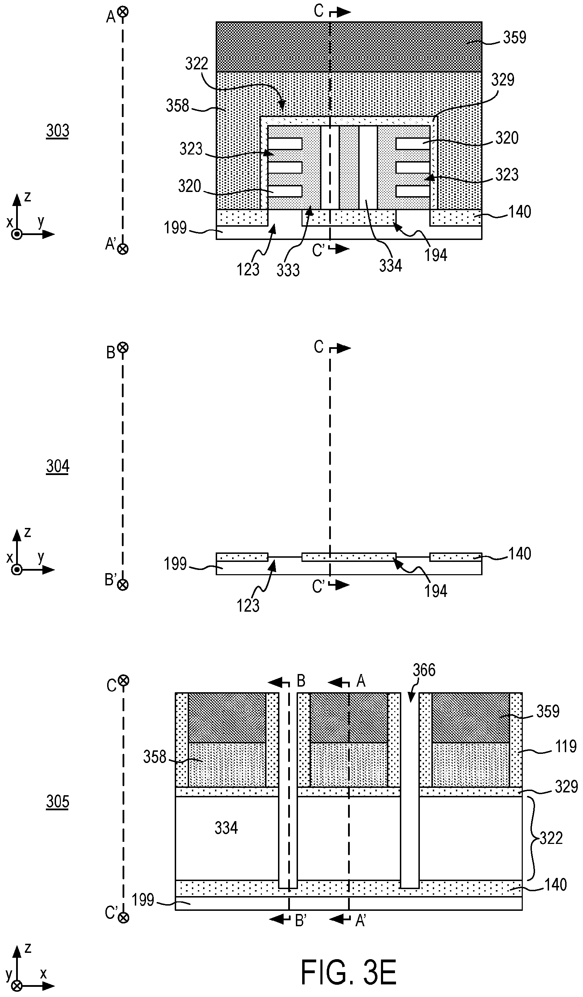

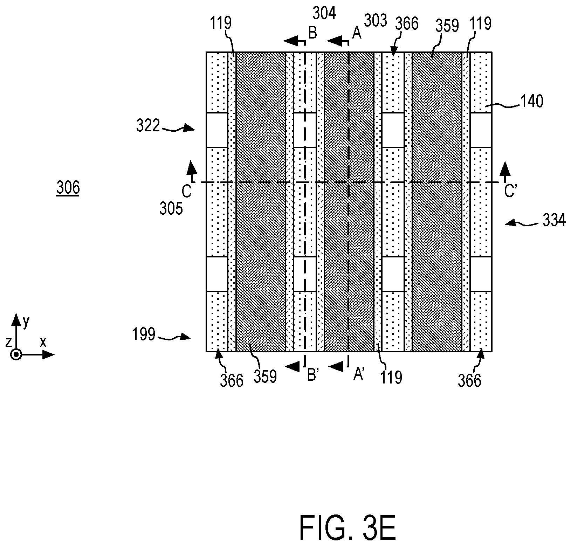

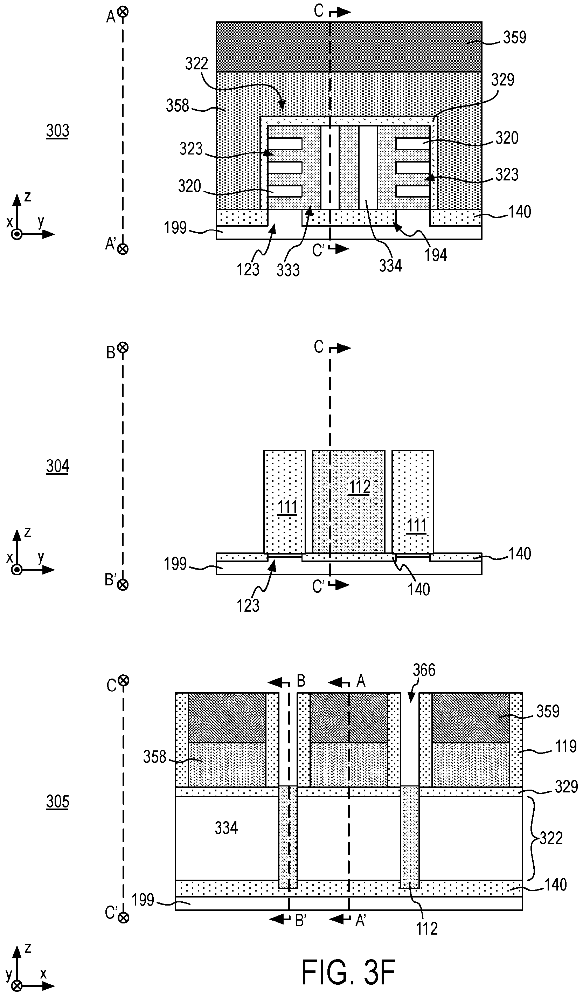

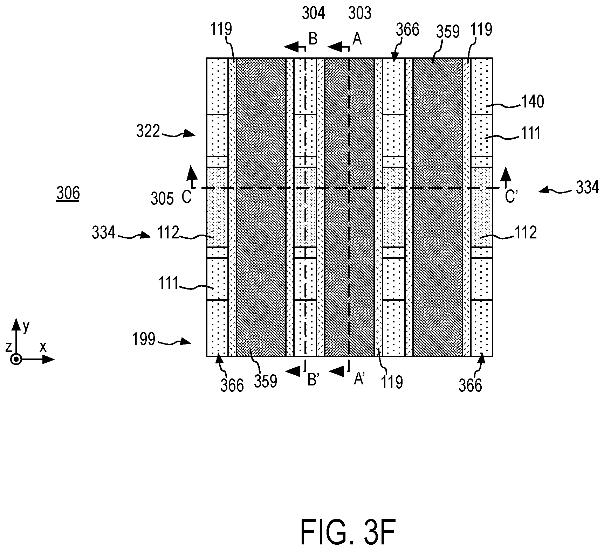

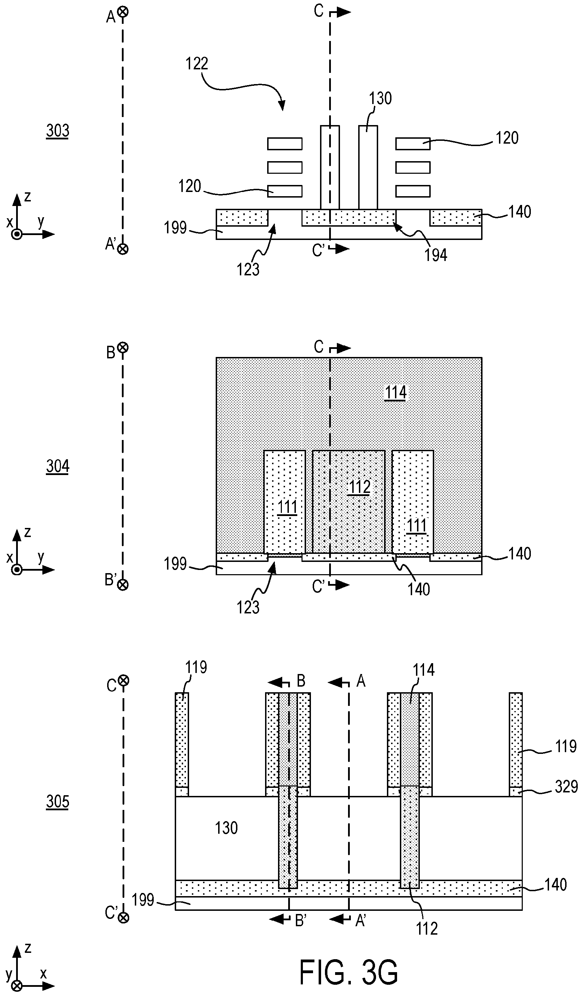

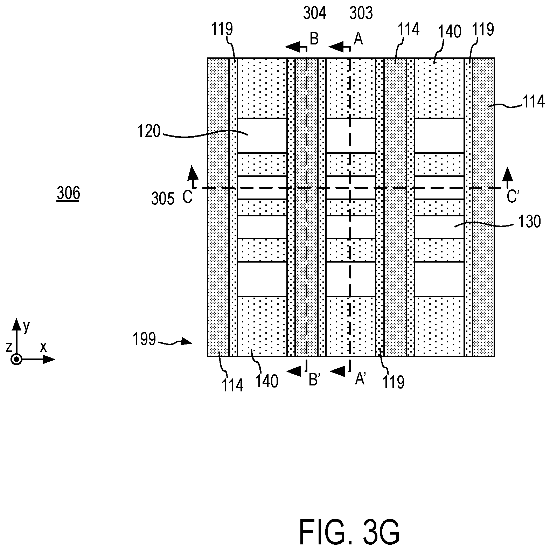

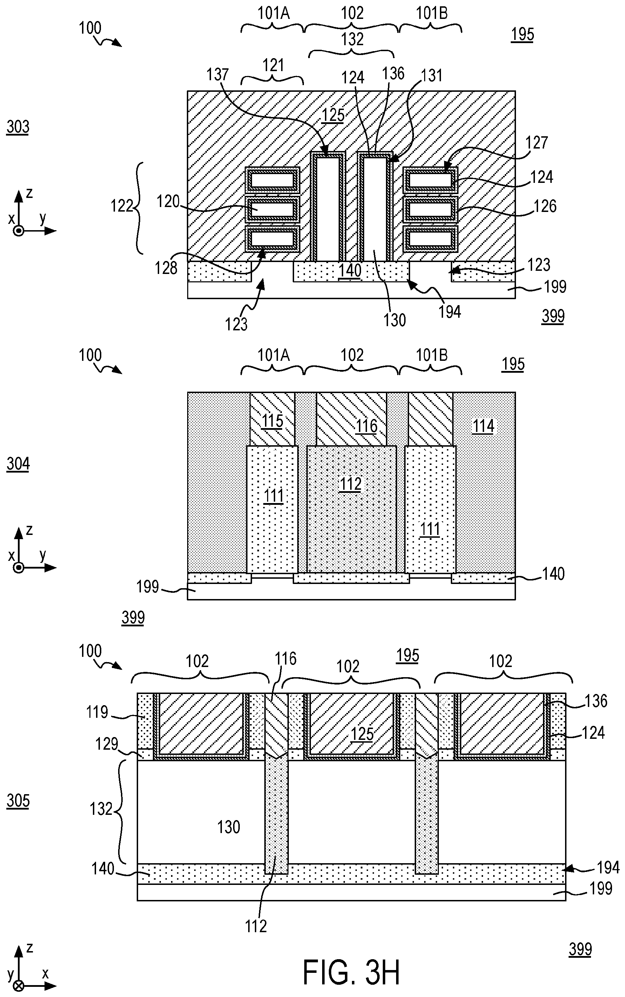

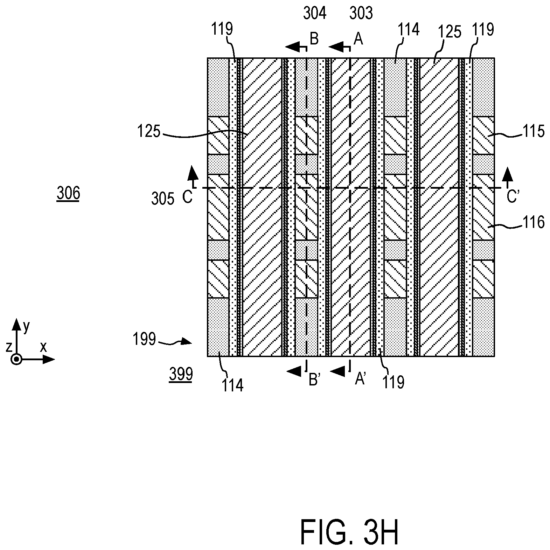

FIGS. 3A, 3B, 3C, 3D, 3E, 3F, 3G, and 3H illustrate cross-sectional profile and plan views of workpiece or device 100 having FinFET structure 102 adjacent GAA FET structures 101, at various stages of manufacture, in accordance with some embodiments. FIGS. 3A-3H show possible examples of intermediate structures during an embodiment of a practice of methods 200 of FIG. 2.

Returning to FIG. 2, methods 200 begin at operation 210 with depositing a blocking material. The blocking material may be deposited on or over a sidewall of a material stack to prevent subsequent crystalline growth on the sidewall. In many embodiments, the material stack includes layers of a channel material and layers of a sacrificial material. The channel and sacrificial material layers may be alternating (e.g., interleaved with each other).

The blocking material may be deposited on or over one sidewall to prevent growth while leaving exposed an opposite sidewall (e.g., on the other side of the material stack) that may serve as a growth template for epitaxial growth of a crystalline lattice. The blocking material may be any suitable material and may be deposited by any suitable means. The blocking material may be a material that inhibits growth (e.g., deposition) of the channel and sacrificial materials, which may subsequently be selectively deposited on the exposed sidewall. In many embodiments, the blocking material includes carbon, nitrogen, or oxide. In many embodiments, the blocking material is deposited (either conformally or by blanket deposition) and patterned (e.g., removed) by a lithographic operation (e.g., masking the area to leave unblocked, depositing the blocking material in unmasked areas, and removing the masking material). In many embodiments, the blocking material is deposited on a first sidewall of multiple material stacks, and a second sidewall is exposed opposite the first sidewall. In some such embodiments, pairs of adjacent material stacks have exposed, inner sidewalls facing the other stack of the pair (e.g., with blocking material on the opposing, outer sidewalls).

In some embodiments, the alternating layers of channel and sacrificial materials have approximately equal heights (e.g., layer thicknesses). In other embodiments, one or the other of the channel and sacrificial materials layers are of a significantly greater height or thickness. For example, the sacrificial materials layers may have a greater height or thickness to provide more space (e.g., when removed, replaced by a metal gate) between nanoribbon (channel material) layers. In some embodiments, the alternating channel and sacrificial layers generally have approximately equal heights or thicknesses, but have a thicker or thinner upper and/or lower layer. For example, a top or bottom sacrificial layer may be thicker (or thinner) to provide for a taller fin height (or metal gate height).

The material stack may be received on or in a substrate, such as an IC die or wafer, e.g., much as described of substrate 199 at FIG. 1A. In some embodiments, the material stack is formed on a received substrate. The material stack may be formed by epitaxially depositing the channel and sacrificial materials in layers over the substrate, for example, sequentially by atomic layer deposition (ALD) or other chemical vapor deposition (CVD). Both of the channel and sacrificial materials may be capable of epitaxial deposition into a lattice structure continuous with (e.g., aligned with and matching) the lattice structure of the received substrate. In many embodiments, the received substrate is a silicon wafer, one or both of the (e.g., grown) channel and sacrificial materials include silicon, and one or both of the (e.g., grown) channel and sacrificial materials include germanium. In many embodiments, the received substrate is a (100) silicon wafer, the (e.g., grown) channel material is silicon, and the (e.g., grown) sacrificial material is silicon germanium. In some such embodiments, the channel material and sacrificial material layers have upper and lower (100) surfaces, and the material stack has (e.g., the channel material and sacrificial material layers have) sidewall (110) surfaces. In some such embodiments, a lattice structure is continuous from the crystalline substrate and through the material stack of first and second layers. In some embodiments, the material stack of layers is etched to form the sidewalls (for example, separated by a width of the eventual nanoribbons or nanosheets). In some such embodiments, the etch continues into the substrate (that the material stack is over) and forms a trench in the substrate (e.g., with a trench between two material stacks and sidewalls of the two material stacks facing each other over the trench). Forming the trench may form substrate subfins to either side of the trench (e.g., as trench sidewalls), under the material stacks. The etch may use a hardmask (e.g., lithographically patterned) over the material stack.

FIG. 3A shows a material stack 322 with blocking material 355 on sidewall 325 opposite exposed sidewall 326 in a workpiece or device 100, in accordance with some embodiments, for example, following a performance of depositing operation 210. Blocking material 355 is on outer sidewalls 325, and exposed, inner sidewalls 326 are facing each other over dielectric structure 140. Material stacks 322 are on subfins 123 of substrate 199. Material stacks 322 include alternating channel material layers 320 and sacrificial material layers 323. Hardmask 352 is over stack 322. Isolation structure 140 includes a dielectric material in trench 194. Trench 194 is between two material stacks 322, and sidewalls 326 of stacks 322 are facing each other over trench 194.

At view 303, which is at y-z cross-sectional viewing plane A-A', the orientation of x-z cross-sectional viewing plane C-C' is illustrated, e.g., for reference purposes. View 305 will be at viewing plane C-C', longitudinally through a fin (or vertical nanoribbon) yet to be formed.

At view 306, which is an x-y plan view, the orientations of y-z cross-sectional viewing planes A-A' and B-B' (of views 303, 304, respectively) and x-z cross-sectional viewing plane C-C' (of view 305) are shown, e.g., for illustrative purposes. Blocking material 355 is to the outside of stacks 322, and inner sidewalls 326 are exposed and facing each other over dielectric structure 140. View 303 is at viewing plane A-A', which is transversely through stacks 322 and will be through a gate electrode to be formed over nanoribbons and fins. View 304 is at viewing plane B-B', which is transversely through stacks 322 and will be in a trench between gate electrodes yet to be formed over nanoribbons and fins. (Yet-to-be-formed fins and gate electrodes are illustrated with shaded-in, dotted outlines over structure 140 over substrate 199, e.g., for reference purposes.) Note that the structures shown (e.g., material stacks 322 and blocking materials 355) may continue beyond the edges shown, e.g., in the x-directions.

Returning to FIG. 2, methods 200 continue at operation 220 with growing a layer of the sacrificial material on the exposed sidewall of the material stack. The sacrificial layer may be grown by any suitable means and of any suitable sacrificial material, for example, the same sacrificial material as in the stack of layers. In many embodiments, the new sacrificial material layer is grown on the stack sidewall in the same manner as the sacrificial material layer in the stack of layers, for example, by epitaxial deposition (such as an ALD).

The sacrificial material growth (e.g., laterally, from the stack sidewall) may establish a distance or spacing between a subsequently formed vertical channel layer (e.g., fin or vertical nanoribbon) and the material stack (and the eventual nanoribbons channels in the stack). A channel material layer may be grown on a sidewall of the sacrificial material layer grown here at operation 220, and a thickness of the new sacrificial material layer may set or provide the space between the stack of material layers or nanoribbons and vertical channel material layer (e.g., for gate dielectric(s) and gate metal(s)). In some embodiments, the new sacrificial material layer is grown to a thickness greater than a width or lateral thickness of a subsequently formed vertical channel layer (e.g., width W as described at FIG. 1A). In some such embodiments, the new sacrificial material layer is grown to a thickness less than twice the width or lateral thickness of the subsequently formed vertical channel layer. This range (of between one and two times the fin thickness or width) may provide sufficient space for subsequent gate formation (including removal of sacrificial material and deposition of gate dielectric and metal) while not occupying or consuming excessive lateral (e.g., layout) area. In other embodiments, the new sacrificial material layer is grown to a thickness less than the width or lateral thickness of the subsequently formed vertical channel layer, which may enable tighter device layouts.

The exposed material stack sidewall is a shared sidewall of the channel and sacrificial material layers, and the layer newly grown (here, at operation 220) on the sidewall may continue the lattice structure of the substrate and the material stack channel and sacrificial material layers. In many embodiments, the sacrificial material layer is grown on the stack sidewall by epitaxially depositing the sacrificial material on the stack sidewall (and the channel and sacrificial material layers in the stack). In some such embodiments, the lattice structure of the crystalline substrate is maintained, continuous from the substrate, through the material stack of channel and sacrificial material layers, and to the sacrificial material layer grown on the stack sidewall. In some such embodiments, the sacrificial material layer grown on the stack sidewall has a sidewall (110) surface, e.g., matching, and parallel and continuous with, the material stack sidewall. In many embodiments, the sacrificial material layer grown on the stack sidewall is of the same sacrificial material as in the sacrificial layers of the material stack. In some such embodiments, a layer of silicon germanium sacrificial material is grown on an exposed sidewall of a material stack of silicon channel layers and silicon germanium sacrificial layers over a subfin and substrate of silicon.

Growing laterally from the stack sidewall, the new sacrificial material layer may grow or project out over (and on) an isolation structure adjacent a subfin under the material stack. The isolation structure may be over the substrate (and between a pair of substrate subfins) and may be a base under the newly formed sacrificial material layer.

Growing the layer of the sacrificial material on the exposed sidewall of the material stack may be done concurrently with growing other layers of the sacrificial material on other exposed sidewalls of other material stacks. In some embodiments, pairs of adjacent material stacks have exposed, inner sidewalls facing the other stack of the pair (e.g., with blocking material on the opposing, outer sidewalls). In some such embodiments, the growing the layer of the sacrificial material on the exposed sidewall of the first material stack grows another layer of the sacrificial material on the exposed sidewall of the second material stack (e.g., concurrently), for example, with the newly grown layers of sacrificial material between the first and second material stacks.

Other sacrificial material layers may be grown subsequently, for example, after growing one or more channel material layers (for example, at operation 230). In some embodiments, after pairs of channel material layers have been deposited on pairs of layers of sacrificial material newly grown on pairs of exposed, inner sidewalls of pairs of adjacent material stacks, another layer of the sacrificial material is grown on and between the newly deposited pair of channel material layers (e.g., an innermost pair of layers grown inwards from adjacent material stacks). This layer of sacrificial material may complete the lateral stack growth and, e.g., cover sidewalls of at least channel material layers, which may provide necessary structural strength during subsequent processing.

Returning to FIG. 2, methods 200 continue by growing a layer of the channel material on the layer of sacrificial material on the stack sidewall at operation 230. The channel layer may be grown by any suitable means and of any suitable channel material, for example, the same channel material as in the stack of layers. In many embodiments, the new channel material layer is grown on the sacrificial material layer sidewall in the same manner as the channel material layer in the stack of layers, for example, by epitaxial deposition (such as an ultra-high vacuum or low-pressure CVD (UHVCVD or LPCVD)).

The channel material growth (e.g., laterally, from the sacrificial material layer sidewall) may establish a width or thickness of a channel fin (e.g., vertical nanoribbon), which may ensure sufficient mechanical strength of the fin. In some embodiments, the new channel material layer is grown to a width or lateral thickness (e.g., width W as described at FIG. 1A) greater than a height or vertical thickness of the channel material layers in the material stack. In some embodiments, the new channel material layer is grown to a width or lateral thickness (e.g., width W as described at FIG. 1A) less than or equal to a width or lateral thickness of the previously formed sidewall sacrificial material layer. In some such embodiments, the new channel material layer is grown to a thickness greater than half the width or lateral thickness of the sidewall sacrificial material layer.

The channel layer newly grown (here, at operation 230) on the sacrificial material layer grown on the stack sidewall may continue the lattice structure of the substrate, the material stack channel and sacrificial material layers, and the sacrificial material layer on the sidewall. In many embodiments, the channel material layer is grown on the sidewall sacrificial material layer by epitaxially depositing the channel material on the sidewall sacrificial material layer. In some such embodiments, the lattice structure of the crystalline substrate is maintained, continuous from the substrate, through the material stack of channel and sacrificial material layers, through the sacrificial material layer grown on the stack sidewall, and to the channel material layer grown on the sidewall sacrificial material layer. In some such embodiments, the channel material layer grown on the sidewall sacrificial material layer has a sidewall (110) surface, e.g., matching, and parallel and continuous with, the material stack sidewall. In many embodiments, the channel material layer grown on the sidewall sacrificial material layer is of the same channel material as in the channel layers of the material stack. In some such embodiments, a layer of silicon channel material is grown on a sidewall sacrificial material layer of silicon germanium on a sidewall of the material stack of silicon channel layers and silicon germanium sacrificial layers over a subfin and substrate of silicon.

Growing laterally from the stack sidewall and the layer of sacrificial material on the stack sidewall, the new channel material layer may grow or project out over (and on) the isolation structure adjacent a subfin under the material stack. The isolation structure may be over the substrate (and between a pair of substrate subfins) and may be a base under the newly formed channel material layer.

Growing the layer of the channel material on the sidewall sacrificial material layer may be done concurrently with growing other layers of the channel material on other sidewall sacrificial material layers on other material stacks. In some embodiments, pairs of adjacent material stacks have sidewall sacrificial material layers facing the other stack of the pair (e.g., with blocking material on the opposing, outer sidewalls). In some such embodiments, the growing the layer of the channel material on the sidewall sacrificial material layer of the first material stack grows another layer of the channel material on the sidewall sacrificial material layer of the second material stack (e.g., concurrently), for example, with the newly grown layers of channel material between the first and second material stacks and the sidewall sacrificial material layers on the material stacks.

Other sacrificial and channel material layers may be grown subsequently, for example, to fabricate more fins. In some embodiments, after pairs of channel material layers have been deposited on pairs of sacrificial material layers grown on pairs of sidewalls of adjacent material stacks, another layer of sacrificial material is grown on and between the newly deposited pair of channel material layers (e.g., an innermost pair of layers grown inwards from adjacent material stacks).

FIG. 3B illustrates (e.g., at view 303) vertical sacrificial and channel material layers 333, 334 between material stacks 322 in a workpiece or device 100, in accordance with some embodiments, for example, following a performance of growing operations 220, 230. Vertical sacrificial and channel material layers 333, 334 are on isolation structure 140. Vertical sacrificial material layers 333 are continuous with sacrificial layers 323, e.g., of the same sacrificial material and with the same, uninterrupted lattice structure, for example, as if grown on sidewalls 326, which are not apparent where sacrificial material of layers 323, 333 merges. Vertical channel material layers 334 are on sidewalls of layers 333, between stacks 322. Vertical sacrificial material layer 333B is on and between vertical channel material layers 334.

View 306 shows vertical sacrificial and channel material layers 333, 334 between material stacks 322, covering isolation structure 140 between stacks 322. Vertical sacrificial material layers 333 are immediately adjacent (e.g., on or continuous with) stacks 322. Vertical channel material layers 334 are on vertical sacrificial material layers 333. Dotted outlines of yet-to-be-formed gate electrodes are over substrate 199, e.g., for reference purposes.

Returning to FIG. 2, methods 200 continue with masking the material stack and the sidewall sacrificial and channel layers at operation 240. In many embodiments, the material stack and the sidewall sacrificial and channel layers are masked after removing the blocking materials deposited at operation 210. In many embodiments, the material stack and the sidewall sacrificial and channel layers are masked together. In some such embodiments, the material stack and the sidewall sacrificial and channel layers are masked by growing a passivation layer over the material stack and the sidewall sacrificial and channel layers by depositing a dummy gate over the passivation layer. In some embodiments, the passivation layer is thermally grown. In some embodiments, a masking layer (e.g., of an oxide, such as a silicon oxide) is deposited by ALD. In some such embodiments, a masking layer is deposited by ALD over a thermally grown passivation layer.

A deposited dummy gate may define the channel by masking that portion of the channel material layers. A subsequent etch operation may remove channel material portions not masked. The dummy gate may be any suitable material, for example, having satisfactory etch selectivities with other exposed structures and materials. In many embodiments, the dummy gate includes polycrystalline silicon. In many embodiments, a hardmask is over the dummy gate, e.g., for patterning the dummy gate, etc.

FIG. 3C illustrates (e.g., at view 303) vertical sacrificial and channel material layers 333, 334 and material stacks 322 covered together under masking layer 329 in a workpiece or device 100, in accordance with some embodiments, for example, during or following a performance of masking operation 240. Layer 329 is on a top of stacks 322 and vertical layers 333, 334 and on sidewalls 325 of stacks 322.

View 306 shows masking layer 329 over stacks 322 and layers 333, 334. Dotted and shaded outlines of yet-to-be-formed gate electrodes are over substrate 199, e.g., for reference purposes.

FIG. 3D illustrates dummy gates 358 on masking layer 329 over stacks 322 and layers 333, 334 in a workpiece or device 100, in accordance with some embodiments, for example, following a performance of masking operation 240. Hardmask 359 is on dummy gate 358.

At view 303, cross-sectional plane A-A' is a gate cut through dummy gate 358 on masking layer 329, over and to both sides of stacks 322 and vertical layers 333, 334. Dummy gate 358 is on isolation structure 140 on substrate 199. Hardmask 359 is on a top surface of dummy gate 358. Layers 320, 323, 333, 334 extend through dummy gate 358 in the x-directions. Cross-sectional plane C-C' of view 305 is through vertical channel layer 334 longitudinally.

At view 304, cross-sectional plane B-B' is a trench cut between dummy gates 358. Masking layer 329 is exposed on a top of stacks 322 and vertical layers 333, 334 and on sidewalls 325 of stacks 322. Layers 320, 323, 333, 334 extend in the x-directions, covered together under masking layer 329. Cross-sectional plane C-C' of view 305 is through vertical channel layer 334 longitudinally.

At view 305, cross-sectional plane C-C' is a fin cut through vertical channel layer 334, under and through dummy gates 358. Masking layer 329 is exposed between dummy gates 358, on a top of vertical layer 334. Layer 334 extends in the x-directions, covered by masking layer 329. The orientation of gate cut plane A-A' and trench cut plane B-B' is shown.

At view 306, which is an x-y plan view, the orientations of y-z cross-sectional viewing planes A-A' and B-B' (of gate-cut and trench-cut views 303, 304, respectively) and x-z cross-sectional viewing plane C-C' (of fin-cut view 305) are shown. Masking layer 329 is over substrate 199, exposed between stripes of hardmask 359 (which is over dummy gates 358).

Returning to FIG. 2, methods 200 continue at operation 250 by revealing ends of the channel material layers. Ends of the channel material layers in the material stack and of the vertical (e.g., sidewall) channel material layers may be revealed by etching unmasked portions of the material stack and of the vertical material layers (etching both lateral and vertical material layers, both sacrificial and channel material layers). The unmasked portions may be those portions not masked by the dummy gates. Other masking layers (such as a passivation layer over the stacks and vertical layers, but exposed between the dummy gates) may be removed by an etch between the dummy gates, unmasking those portions not masked by the dummy gates.

Any suitable etch may be used to reveal channel layer ends. In many embodiments, an anisotropic dry etch cuts through the stack and vertical layers, (forming and) revealing layer ends to both sides (e.g., on both sidewalls) of the dummy gate. In many embodiments, a spacer dielectric is conformally deposited over the dummy gate, and the spacer serves as a mask layer on the dummy gate sidewalls, directing the etch between the dummy gates and the spacer mask layer on the dummy gate sidewalls. The etch may be completely through the stack and vertical layers, down to the substrate (e.g., subfins) and isolation structure between the subfins.

FIG. 3E illustrates stack layers 320, 323 and vertical layers 333, 334 etched through between dummy gates 358 in a workpiece or device 100, in accordance with some embodiments, for example, following a performance of revealing operation 250. Lateral and vertical channel layers 320, 334 are now segmented into the more-familiar channel length of nanoribbons and fins.

At view 303, layers 320, 323, 333, 334 are still under masking layer 329 and covered by dummy gate 358.

At view 304, between dummy gates 358, stacks 322 and vertical layers 333, 334 (and layer 329) are absent. Substrate 199 and isolation structure 140 (both etched down somewhat) are exposed.

At view 305, spacer layers 119 are on sidewalls of dummy gate 358 and hardmask 359. Cuts or openings 366 are between spacer layers 119 and through vertical layer 334 (and stack 322) and masking layer 329. Cuts or openings 366 are down to and somewhat into isolation structure 140.

At view 306, spacer layers 119 are on sidewalls of hardmask 359 (and dummy gate 358, under hardmask 359). Cuts or openings 366 are between spacer layers 119 and down to isolation structure 140 and substrate 199.

Returning to FIG. 2, methods 200 continue at operation 260 with growing source and drain bodies on ends of the channel material layers. The source and drain bodies may be any suitable material and may be grown by any suitable means. In many embodiments, source and drain bodies are grown by epitaxially depositing semiconductor material on ends of the channel material layers as crystalline bodies. In many such embodiments, source and drain bodies are grown by epitaxially depositing very small quantities of an acceptor or donor impurity (e.g., as p- or n-type dopants) with the semiconductor material. In many embodiments, source and drain bodies are grown on ends of channel material after sacrificial material is recessed back from the ends. Ends of both the lateral and vertical, sacrificial and channel material layers may be revealed by etching at operation 250. A recess etch may selectively remove revealed sacrificial material at the layer ends. In some embodiments, a dielectric material is deposited adjacent channel material (e.g., between channel material layers in the material stack, replacing sacrificial material), at least at the layer ends.

Separate source and drain bodies may be grown on the ends of the lateral channel material layers in the stacks and on the ends of the vertical, sidewall channel material layers. For example, first source and drain bodies grown on the ends of the lateral channel material layers (e.g., nanoribbons) in the stacks may be as described of source and drain bodies 111 at FIG. 1A, and second source and drain bodies grown on the ends of the vertical channel material layers (e.g., fins) may be as described of source and drain bodies 112 at FIG. 1A. First source and drain bodies may grow on the ends of each of the lateral channel material layers (e.g., nanoribbons) and may merge into a single source or drain body for each material stack. Second source and drain bodies may grow on the ends of each of the vertical channel material layers (e.g., fins) and may merge into a single source or drain body for a group of fins.

Separate materials may be used to form the first and second source and drain bodies, for example, based on a conductivity type of a transistor structure. In many embodiments, growing the first source and drain bodies includes epitaxially depositing a first semiconductor material and an acceptor impurity on the ends of the lateral channel material layers (e.g., nanoribbons), and growing the second source and drain bodies includes epitaxially depositing a second semiconductor material and a donor impurity on the ends of the vertical channel material layers (e.g., fins). In some embodiments, the first and second semiconductor materials are the same semiconductor material (for example, a Group IV semiconductor material, as described at FIG. 1A). In some embodiments, different semiconductor materials are used for the first and second semiconductor materials (for example, silicon for n-type source and drain bodies and germanium or silicon germanium for p-type source and drain bodies).

FIG. 3F illustrates source and drain bodies 111, 112 on ends of channel material layers 320, 334 in a workpiece or device 100, in accordance with some embodiments, for example, following a performance of growing operation 260.

At view 303, layers 320, 323, 333, 334 are still under masking layer 329 and covered by dummy gate 358.

At trench-cut view 304, source and drain bodies 111, 112 are over substrate 199 and on isolation structure 140. Each stack 322 has a single source or drain body 111, and the group of fins has a single source or drain body 112.

At view 305, source and drain bodies 112 are in openings 366 between layers 119, 329 and vertical channel layers 334 (e.g., fins). Source and drain bodies 112 are on ends of layers 334 and on isolation structure 140.

At view 306, spacer layers 119 are on sidewalls of hardmask 359. Source and drain bodies 112 are over isolation structure 140 and substrate 199 in openings 366 between spacer layers 119.

Returning to FIG. 2, methods 200 continue with exposing the lateral and vertical channel material layers at operation 270. The channel material layers may be exposed by removing the lateral and vertical sacrificial material layers. The sacrificial material layers may be removed by any suitable means, for example, by a selective, isotropic dry etch following a removal of the dummy gate (and hardmask, in some embodiments). In many embodiments, silicon germanium sacrificial layers (e.g., lateral and vertical) are removed by an etch selective to silicon channel layers (e.g., nanoribbons and fins). In many embodiments, exposed channel material layers in the stack (e.g., nanoribbons) have (100) top and bottom surfaces, and exposed, vertical channel material layers (e.g., fins) have (110) sidewall surfaces.

FIG. 3G illustrates exposed nanoribbons 120 and fins 130 in a workpiece or device 100, in accordance with some embodiments, for example, following a performance of exposing operation 270.

At view 303, nanoribbons 120 in stack 122 (over subfin 123) and fins 130 on isolation structure 140 are exposed.

At trench-cut view 304, source and drain bodies 111, 112 are over substrate 199 and isolation structure 140. Dielectric 114 is over and to both sides of source and drain bodies 111, 112, filling the trench between spacer layers.

At view 305, fins 130 are exposed over isolation structure 140. Source and drain bodies 112 are on ends of fins 130 and on isolation structure 140. Layers 119, 129 are over fins 130 adjacent bodies 112. Dielectric 114 is over source and drain bodies 112, filling the spacer between spacer layers 119.

At view 306, nanoribbons 120 and fins 130 are exposed over isolation structure 140. Spacer layers 119 are over nanoribbons 120 and fins 130 adjacent bodies 111, 112. Dielectric 114 is over source and drain bodies 111, 112 between spacer layers 119.

Returning to FIG. 2, methods 200 continue at operation 280 by depositing gate materials over the channel material layers. The gate materials may be any suitable materials and may be deposited by any suitable means. The gate materials may include one or more suitable dielectric materials, e.g., much as described at FIG. 1A of gate dielectric layer(s) 124. The gate materials may include one or more suitable metals, e.g., much as described at FIG. 1A of gate electrodes 125, 135 (including layers 126, 136). The gate metals may be deposited over a gate dielectric, which may be deposited conformally over the channel material layers. In many embodiments, a high-K dielectric layer is deposited conformally over the channel material layers. In some such embodiments, the high-K dielectric layer is deposited conformally on a passivation layer thermally grown over the channel material layers.

A seed and/or barrier layer metal, e.g., a WFM, may be conformally deposited over gate dielectric layers. In many embodiments, depositing the gate materials over the lateral channel material layers (e.g., nanoribbons) includes depositing an n-type WFM over the lateral channel material layers, and depositing the gate materials over the vertical channel material layers (e.g., fins) includes depositing a p-type WFM over the vertical channel material layers.

FIG. 3H illustrates FET structures 101, 102 having channel regions 121, 132 of nanoribbons 120 and fins 130, respectively, in IC device 100, in accordance with some embodiments, for example, following a performance of depositing operation 280. Device 100 is substantially as described of the embodiments of FIG. 1A. Notably, FET structures 101, 102 include shared gate electrode 125 over nanoribbons 120 and fins 130, including a common bulk or fill metal of electrode 125 over respective metal layers 126, 136.

At view 303, nanoribbons 120 in stack 122 and fins 130 extend through electrode 125. Fins 130 are on isolation structure 140. FET structure 101 includes n-WFM layer 126 on gate dielectric layer 124. FET structure 102 includes p-WFM layer 136 on gate dielectric layer 124.

At trench-cut view 304, contact structures 115, 116 are on and over source and drain bodies 111, 112 and through isolation dielectric 114. Dielectric 114 is over and to both sides of source and drain bodies 111, 112, filling the trench between spacer layers.

At view 305, gate electrode 125 is over fin 130, separated from fin 130 by gate dielectric layer 124. Metal layer 126 is on layer 124. Gate dielectric layer 124 is conformally on spacer layers 119.

At view 306, stripes of gate electrodes 125 are over nanoribbons 120 and fins 130. Contact structures 115, 116 are over and through isolation dielectric 114 in trenches between electrodes 125. Spacer layers 119 are between electrodes 125 and structures 115, 116. Isolation dielectric 114 is between electrodes 125.

IC device 100 may include or be coupled to a substrate or other host component 399. Host component 399 may be a package substrate, an interposer, an IC die, etc. For example, substrate 199 may be an IC die that includes transistor structures 101, substrate 199 may be coupled (e.g., soldered or otherwise bonded) to host component 399, and transistor structure 101 may be coupled to a power supply (not shown) through host component 399.

Host component 399 is a planar platform and may include dielectric and metallization structures. Host component 399 mechanically supports and electrically couples one or more IC devices 100. At least one side of host component 399 includes substrate interconnect interfaces for bonding to one or more IC devices 100. IC device 100 may be direct bonded, e.g., hybrid bonded, to host component 399 or otherwise bonded, e.g., by optional solder bumps. The opposite side of host component 399 may include similar interfaces, e.g., copper pads for socketing and/or solder bumps for bonding device 100 to a host component, such as a printed circuit board (PCB). Host component 399 may be any host component with substrate interconnect interfaces, such as a package host component 399 or interposer, etc. Host component 399 may itself be a die. In many embodiments, host component 399 includes organic dielectric(s), such as a resin or other polymer, between metallization layers.

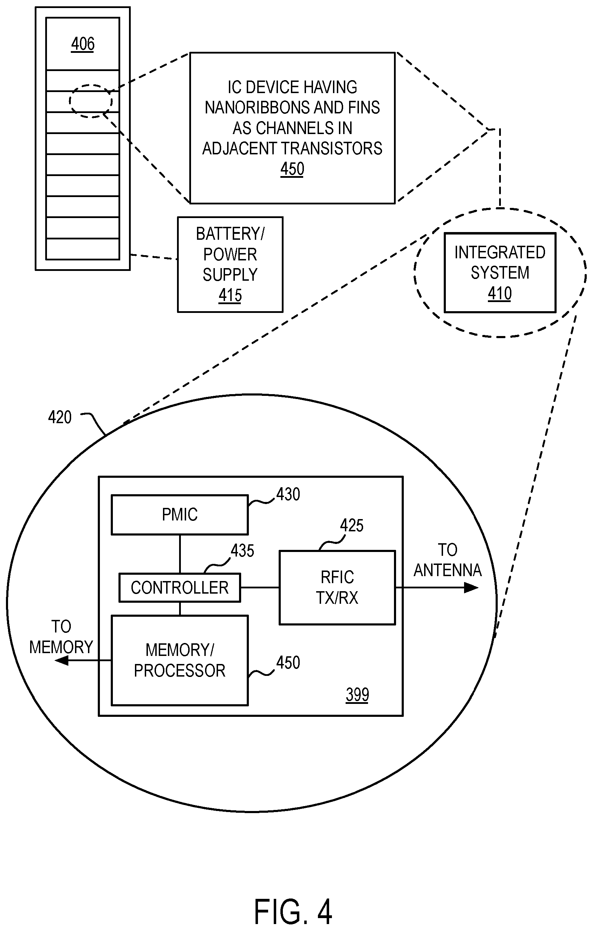

FIG. 4 illustrates a diagram of an example data server machine 406 employing an IC device having nanoribbons and fins as channels in adjacent transistors, in accordance with some embodiments. Server machine 406 may be any commercial server, for example, including any number of high-performance computing platforms disposed within a rack and networked together for electronic data processing, which in the exemplary embodiment includes one or more devices 450 having nanoribbons and fins as channels in adjacent transistors.

Also as shown, server machine 406 includes a battery and/or power supply 415 to provide power to devices 450, and to provide, in some embodiments, power delivery functions such as power regulation. Devices 450 may be deployed as part of a package-level integrated system 410. Integrated system 410 is further illustrated in the expanded view 420. In the exemplary embodiment, devices 450 (labeled "Memory/Processor") includes at least one memory chip (e.g., random-access memory (RAM)), and/or at least one processor chip (e.g., a microprocessor, a multi-core microprocessor, or graphics processor, or the like) having the characteristics discussed herein. In an embodiment, device 450 is a microprocessor including a static RAM (SRAM) cache memory. As shown, device 450 may be an IC device having nanoribbons and fins as channels in adjacent transistors, as discussed herein. Device 450 may be further coupled to (e.g., communicatively coupled to) a board, an interposer, or other substrate or host component 399 along with, one or more of a power management IC (PMIC) 430, RF (wireless) IC (RFIC) 425 including a wideband RF (wireless) transmitter and/or receiver (TX/RX) (e.g., including a digital baseband and an analog front end module further includes a power amplifier on a transmit path and a low noise amplifier on a receive path), and a controller 435 thereof. In some embodiments, RFIC 425, PMIC 430, controller 435, and device 450 include having nanoribbons and fins as channels in adjacent transistors.

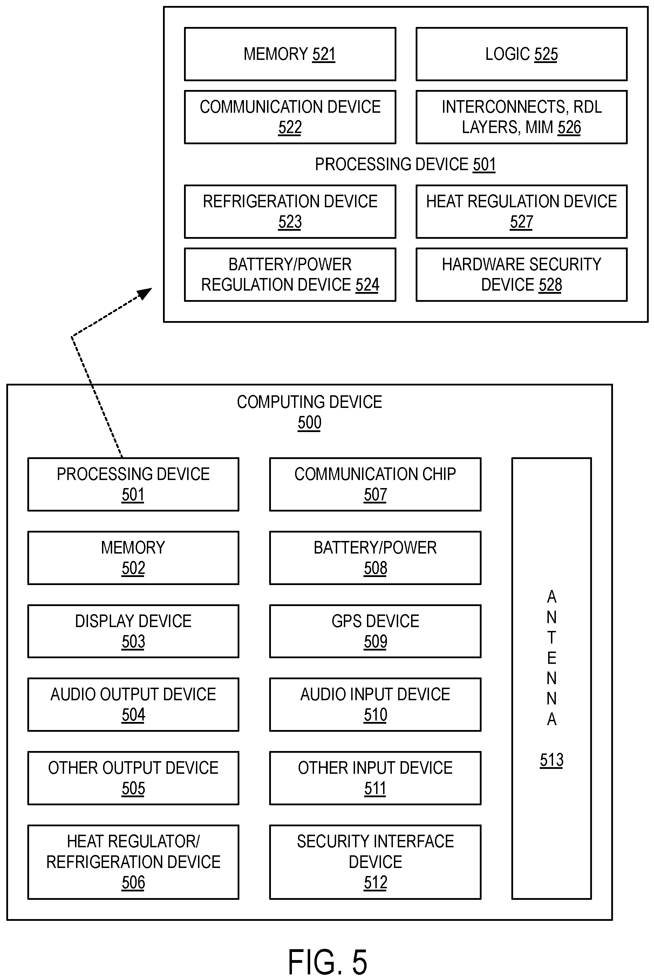

FIG. 5 is a block diagram of an example computing device 500, in accordance with some embodiments. For example, one or more components of computing device 500 may include any of the devices or structures discussed herein. A number of components are illustrated in FIG. 5 as being included in computing device 500, but any one or more of these components may be omitted or duplicated, as suitable for the application. In some embodiments, some or all of the components included in computing device 500 may be attached to one or more printed circuit boards (e.g., a motherboard). In some embodiments, various ones of these components may be fabricated onto a single system-on-a-chip (SoC) die. Additionally, in various embodiments, computing device 500 may not include one or more of the components illustrated in FIG. 5, but computing device 500 may include interface circuitry for coupling to the one or more components. For example, computing device 500 may not include a display device 503, but may include display device interface circuitry (e.g., a connector and driver circuitry) to which display device 503 may be coupled. In another set of examples, computing device 500 may not include an audio output device 504, other output device 505, global positioning system (GPS) device 509, audio input device 510, or other input device 511, but may include audio output device interface circuitry, other output device interface circuitry, GPS device interface circuitry, audio input device interface circuitry, audio input device interface circuitry, to which audio output device 504, other output device 505, GPS device 509, audio input device 510, or other input device 511 may be coupled.

Computing device 500 may include a processing device 501 (e.g., one or more processing devices). As used herein, the term "processing device" or "processor" indicates a device that processes electronic data from registers and/or memory to transform that electronic data into other electronic data that may be stored in registers and/or memory. Processing device 501 may include a memory 521, a communication device 522, a refrigeration device 523, a battery/power regulation device 524, logic 525, interconnects 526 (i.e., optionally including redistribution layers (RDL) or metal-insulator-metal (MIM) devices), a heat regulation device 527, and a hardware security device 528.

Processing device 501 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices.

Computing device 500 may include a memory 502, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, memory 502 includes memory that shares a die with processing device 501. This memory may be used as cache memory and may include embedded dynamic random-access memory (eDRAM) or spin transfer torque magnetic random-access memory (STT-MRAM).

Computing device 500 may include a heat regulation/refrigeration device 506. Heat regulation/refrigeration device 506 may maintain processing device 501 (and/or other components of computing device 500) at a predetermined low temperature during operation.

In some embodiments, computing device 500 may include a communication chip 507 (e.g., one or more communication chips). For example, the communication chip 507 may be configured for managing wireless communications for the transfer of data to and from computing device 500. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 507 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. Communication chip 507 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. Communication chip 507 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 507 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. Communication chip 507 may operate in accordance with other wireless protocols in other embodiments. Computing device 500 may include an antenna 513 to facilitate wireless communications and/or to receive other wireless communications (such as AM or FM radio transmissions).

In some embodiments, communication chip 507 may manage wired communications, such as electrical, optical, or any other suitable communication protocols (e.g., the Ethernet). As noted above, communication chip 507 may include multiple communication chips. For instance, a first communication chip 507 may be dedicated to shorter-range wireless communications such as Wi-Fi or Bluetooth, and a second communication chip 507 may be dedicated to longer-range wireless communications such as GPS, EDGE, GPRS, CDMA, WiMAX, LTE, EV-DO, or others. In some embodiments, a first communication chip 507 may be dedicated to wireless communications, and a second communication chip 507 may be dedicated to wired communications.

Computing device 500 may include battery/power circuitry 508. Battery/power circuitry 508 may include one or more energy storage devices (e.g., batteries or capacitors) and/or circuitry for coupling components of computing device 500 to an energy source separate from computing device 500 (e.g., AC line power).

Computing device 500 may include a display device 503 (or corresponding interface circuitry, as discussed above). Display device 503 may include any visual indicators, such as a heads-up display, a computer monitor, a projector, a touchscreen display, a liquid crystal display (LCD), a light-emitting diode display, or a flat panel display, for example.

Computing device 500 may include an audio output device 504 (or corresponding interface circuitry, as discussed above). Audio output device 504 may include any device that generates an audible indicator, such as speakers, headsets, or earbuds, for example.

Computing device 500 may include an audio input device 510 (or corresponding interface circuitry, as discussed above). Audio input device 510 may include any device that generates a signal representative of a sound, such as microphones, microphone arrays, or digital instruments (e.g., instruments having a musical instrument digital interface (MIDI) output).

Computing device 500 may include a GPS device 509 (or corresponding interface circuitry, as discussed above). GPS device 509 may be in communication with a satellite-based system and may receive a location of computing device 500, as known in the art.

Computing device 500 may include other output device 505 (or corresponding interface circuitry, as discussed above). Examples of the other output device 505 may include an audio codec, a video codec, a printer, a wired or wireless transmitter for providing information to other devices, or an additional storage device.

Computing device 500 may include other input device 511 (or corresponding interface circuitry, as discussed above). Examples of the other input device 511 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 500 may include a security interface device 512. Security interface device 512 may include any device that provides security measures for computing device 500 such as intrusion detection, biometric validation, security encode or decode, access list management, malware detection, or spyware detection.

Computing device 500, or a subset of its components, may have any appropriate form factor, such as a hand-held or mobile computing device (e.g., a cell phone, a smart phone, a mobile internet device, a music player, a tablet computer, a laptop computer, a netbook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device.

The subject matter of the present description is not necessarily limited to specific applications illustrated in FIGS. 1A-5. The subject matter may be applied to other deposition applications, as well as any appropriate manufacturing application, as will be understood to those skilled in the art.

The following examples pertain to further embodiments, and specifics in the examples may be used anywhere in one or more embodiments.

In one or more first embodiments, an apparatus includes a first channel region including a stack of nanoribbons over a substrate, the stack of nanoribbons between a first pair of first source and drain bodies in a first transistor structure, and a second channel region including one or more fins between a second pair of second source and drain bodies in a second transistor structure, the one or more fins standing substantially vertically, substantially orthogonal to the nanoribbons, the one or more fins on a dielectric structure over the substrate.

In one or more second embodiments, further to the first embodiments, an upper surface of a first of the nanoribbons is a (100) surface, and a sidewall of a first of the one or more fins is a (110) surface.

In one or more third embodiments, further to the first or second embodiments, the dielectric structure is a first dielectric structure, the stack of nanoribbons is over a subfin, the substrate including the subfin, and the subfin is between the first dielectric structure and a second dielectric structure over the substrate.

In one or more fourth embodiments, further to the first through third embodiments, the subfin is a first subfin, the stack of nanoribbons is a first stack of the nanoribbons over the first subfin, and the first dielectric structure is between the first stack of the nanoribbons over the first subfin and a second stack of the nanoribbons over a second subfin.

In one or more fifth embodiments, further to the first through fourth embodiments, first and second fins of the one or more fins are between the second pair of second source and drain bodies, and the second transistor structure includes a gate electrode over the first and second fins.

In one or more sixth embodiments, further to the first through fifth embodiments, the first pair of first source and drain bodies include donor impurities, and the second pair of second source and drain bodies include acceptor impurities.

In one or more seventh embodiments, further to the first through sixth embodiments, the first transistor structure includes a first gate electrode, the nanoribbons extend through the first gate electrode, the first gate electrode includes an n-type work function metal (WFM), the second transistor structure includes a second gate electrode over the one or more fins, and the second gate electrode includes a p-type WFM.

In one or more eighth embodiments, further to the first through seventh embodiments, a first upper surface of the one or more fins is at a first height over a second height of a second upper surface of the stack of nanoribbons.

In one or more ninth embodiments, further to the first through eighth embodiments, the stack of nanoribbons is separated from the one or more fins by a distance greater than a width of a first of the one or more fins and less than twice the width of the first of the one or more fins.

In one or more tenth embodiments, an apparatus includes first, second, and third transistor structures over a substrate, a first stack of lateral nanoribbons in the first transistor structure and a second stack of lateral nanoribbons in the second transistor structure, the first stack of lateral nanoribbons over a first subfin and between a first pair of first source and drain bodies, the second stack of lateral nanoribbons over a second subfin and between a second pair of first source and drain bodies, the substrate including the first and second subfins, and a vertical nanoribbon between a third pair of second source and drain bodies in the third transistor structure, between the first and second transistor structures, the vertical nanoribbon on a dielectric structure in a trench over the substrate, the trench between the first and second subfins.

In one or more eleventh embodiments, further to the tenth embodiments, an upper surface of a first of the lateral nanoribbons is a (100) surface, and a sidewall of the vertical nanoribbon is a (110) surface.

In one or more twelfth embodiments, further to the tenth or eleventh embodiments, the first source and drain bodies include an n-type dopant, and the second source and drain bodies include a p-type dopant.

In one or more thirteenth embodiments, further to the tenth through twelfth embodiments, an n-type work function metal (WFM) is over and between the lateral nanoribbons in the first and second stacks of lateral nanoribbons, and a p-type WFM is over the vertical nanoribbon.

In one or more fourteenth embodiments, further to the tenth through thirteenth embodiments, the apparatus also includes a host component, the substrate coupled to the host component, the first, second, and third transistor structures coupled to a power supply through the host component.

In one or more fifteenth embodiments, a method includes depositing a blocking material over a first sidewall of a material stack, opposite an exposed second sidewall of the material stack, the material stack including alternating first layers of a channel material and second layers of a sacrificial material, growing a third layer of the sacrificial material on the second sidewall and the first and second layers, growing a fourth layer of the channel material on the third layer of the sacrificial material, exposing the first and fourth layers of the channel material by removing the second and third layers of the sacrificial material, and depositing gate materials over the first and fourth layers of the channel material.

In one or more sixteenth embodiments, further to the fifteenth embodiments, the growing the fourth layer of the channel material on the third layer of the sacrificial material grows the fourth layer of the channel material with a sidewall (110) surface, and a first of the first layers of the channel material of the material stack includes an upper (100) surface.

In one or more seventeenth embodiments, further to the fifteenth or sixteenth embodiments, the growing the third layer includes epitaxially depositing the sacrificial material on the second sidewall and the first and second layers of the material stack, the growing the fourth layer includes epitaxially depositing the channel material on the third layer of the sacrificial material, the material stack of first and second layers is over a crystalline substrate, and a lattice structure is continuous from the crystalline substrate, through the material stack of first and second layers, and to the third and fourth layers.

In one or more eighteenth embodiments, further to the fifteenth through seventeenth embodiments, the growing the third layer and the growing the fourth layer grows the third and fourth layers over an isolation structure adjacent a subfin under the material stack, and a crystalline substrate is under the isolation structure, the crystalline substrate including the subfin.

In one or more nineteenth embodiments, further to the fifteenth through eighteenth embodiments, the method also includes growing first source and drain bodies on first ends of the first layers and second source and drain bodies on second ends of the fourth layer, wherein the growing the first source and drain bodies on the first ends of the first layers includes epitaxially depositing a first semiconductor material and an acceptor impurity on the first ends of the first layers, and the growing the second source and drain bodies on the second ends of the fourth layer includes epitaxially depositing a second semiconductor material and a donor impurity on the second ends of the second layers.

In one or more twentieth embodiments, further to the fifteenth through nineteenth embodiments, the material stack is a first material stack, the growing the third layer of the sacrificial material on the second sidewall and the first and second layers of the first material stack grows a fifth layer of the sacrificial material on a third sidewall of a second material stack, the third, fourth, and fifth layers between the first and second material stacks, the fourth layer between the third and fifth layers, the growing the fourth layer of the channel material on the third layer of the sacrificial material grows a sixth layer of the channel material on the fifth layer of the sacrificial material on the third sidewall of the second material stack, the fourth and sixth layers between the third and fifth layers, and the method also includes growing a seventh layer of the sacrificial material between the fourth and sixth layers.

The disclosure can be practiced with modification and alteration, and the scope of the appended claims is not limited to the embodiments so described. For example, the above embodiments may include specific combinations of features. However, the above embodiments are not limiting in this regard and, in various implementations, the above embodiments may include the undertaking only a subset of such features, undertaking a different order of such features, undertaking a different combination of such features, and/or undertaking additional features than those features explicitly listed. The scope of the patent rights should, therefore, be determined with reference to the appended claims, along with the full scope of equivalents to which such claims are entitled.

## Claims

1. An apparatus, comprising:
a first channel region comprising a stack of nanoribbons over a substrate, the stack of nanoribbons between a first pair of first source and drain bodies in a first transistor structure; and
a second channel region comprising one or more fins between a second pair of second source and drain bodies in a second transistor structure, the one or more fins standing substantially vertically, substantially orthogonal to the nanoribbons, the one or more fins on a dielectric structure over the substrate.

2. The apparatus of claim 1, wherein:
an upper surface of a first of the nanoribbons is a (100) surface; and
a sidewall of a first of the one or more fins is a (110) surface.

3. The apparatus of claim 1 or 2, wherein:
the dielectric structure is a first dielectric structure;
the stack of nanoribbons is over a subfin, the substrate comprising the subfin; and
the subfin is between the first dielectric structure and a second dielectric structure over the substrate.

4. The apparatus of claim 3, wherein the subfin is a first subfin, the stack of nanoribbons is a first stack of the nanoribbons over the first subfin, and the first dielectric structure is between the first stack of the nanoribbons over the first subfin and a second stack of the nanoribbons over a second subfin.

5. The apparatus of claim 4, wherein first and second fins of the one or more fins are between the second pair of second source and drain bodies, and the second transistor structure comprises a gate electrode over the first and second fins.

6. The apparatus of any of claims 1 to 5, wherein the first pair of first source and drain bodies comprise donor impurities, and the second pair of second source and drain bodies comprise acceptor impurities.

7. The apparatus of any of claims 1 to 6, wherein:
the first transistor structure comprises a first gate electrode;
the nanoribbons extend through the first gate electrode;
the first gate electrode comprises an n-type work function metal (WFM);
the second transistor structure comprises a second gate electrode over the one or more fins; and
the second gate electrode comprises a p-type WFM.

8. The apparatus of any of claims 1 to 7, wherein a first upper surface of the one or more fins is at a first height over a second height of a second upper surface of the stack of nanoribbons.

9. The apparatus of any of claims 1 to 8, wherein the stack of nanoribbons is separated from the one or more fins by a distance greater than a width of a first of the one or more fins and less than twice the width of the first of the one or more fins.

10. The apparatus of any of claims 1 to 9, comprising:
a host component coupled to the substrate; and
a power supply coupled to the first and second transistor structures through the host component.

11. A method, comprising:
depositing a blocking material over a first sidewall of a material stack, opposite an exposed second sidewall of the material stack, the material stack comprising alternating first layers of a channel material and second layers of a sacrificial material;
growing a third layer of the sacrificial material on the second sidewall and the first and second layers;
growing a fourth layer of the channel material on the third layer of the sacrificial material;
exposing the first and fourth layers of the channel material by removing the second and third layers of the sacrificial material; and
depositing gate materials over the first and fourth layers of the channel material.

12. The method of claim 11, wherein the growing the fourth layer of the channel material on the third layer of the sacrificial material grows the fourth layer of the channel material with a sidewall (110) surface, and a first of the first layers of the channel material of the material stack comprises an upper (100) surface.

13. The method of claim 11 or 12, wherein:
the growing the third layer comprises epitaxially depositing the sacrificial material on the second sidewall and the first and second layers of the material stack;
the growing the fourth layer comprises epitaxially depositing the channel material on the third layer of the sacrificial material;
the material stack of first and second layers is over a crystalline substrate; and
a lattice structure is continuous from the crystalline substrate, through the material stack of first and second layers, and to the third and fourth layers.

14. The method of any of claims 11 to 13, wherein:
the growing the third layer and the growing the fourth layer grows the third and fourth layers over an isolation structure adjacent a subfin under the material stack; and
a crystalline substrate is under the isolation structure, the crystalline substrate comprising the subfin.

15. The method of any of claims 11 to 14, further comprising growing first source and drain bodies on first ends of the first layers and second source and drain bodies on second ends of the fourth layer, wherein:
the growing the first source and drain bodies on the first ends of the first layers comprises epitaxially depositing a first semiconductor material and an acceptor impurity on the first ends of the first layers; and
the growing the second source and drain bodies on the second ends of the fourth layer comprises epitaxially depositing a second semiconductor material and a donor impurity on the second ends of the second layers.
